(19) Europäisches Patentamt
European Patent Office
Office européen des brevets

(11) **EP 4 138 260 B1**

(12) **EUROPEAN PATENT SPECIFICATION**

(45) Date of publication and mention
of the grant of the patent:
**12.06.2024 Bulletin 2024/24**

(21) Application number: **22189126.0**

(22) Date of filing: **05.08.2022**

(51) International Patent Classification (IPC):
**H02J 7/00** *(2006.01)*     **G01R 31/392** *(2019.01)*

(52) Cooperative Patent Classification (CPC):
**H02J 7/005; G01R 31/392**

(54) **METHOD FOR DETERMINING THE STATE OF HEALTH OF AT LEAST ONE ELECTRIC BATTERY**

VERFAHREN ZUM BESTIMMEN DES GESUNDHEITSZUSTANDS MINDESTENS EINER ELEKTRISCHEN BATTERIE

PROCÉDÉ PERMETTANT DE DÉTERMINER L'ÉTAT DE SANTÉ D'AU MOINS UNE BATTERIE ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.08.2021 IT 202100021923**

(43) Date of publication of application:
**22.02.2023 Bulletin 2023/08**

(73) Proprietor: **Agenzia Nazionale Per Le Nuove Tecnologie,
L'Energia E Lo Sviluppo Economico Sostenibile (ENEA)
00196 Roma (IT)**

(72) Inventors:
• **PASQUALI, Manlio
  00156 Roma (IT)**
• **VELLUCCI, Francesco
  00062 Bracciano (RM) (IT)**
• **ANDRENACCI, Natascia
  00066 Manziana (RM) (IT)**

(74) Representative: **Primiceri, Maria Vittoria et al
Praxi Intellectual Property S.p.A.
Via Leonida Bissolati, 20
00187 Roma (IT)**

(56) References cited:
**US-A1- 2015 260 795**

**Description**

TECHNICAL FIELD

The present invention relates to a method for determining the state of health of at least one electric battery. More in detail, the present invention refers to a method for detecting electrical quantities indicative of the degradation of at least one electric battery.

Therefore, the present invention finds advantageous use in the technical sector of the production and marketing of electric batteries and more particularly in the technical sector of the production of software and algorithms for systems and devices for the management of electric batteries (known with the English acronym BMS - Battery Management Systems) designed to check the functionality and health of electric batteries.

BACKGROUND ART

Many methods are known in the technical field of reference for determining the state of health of an electric battery. More clearly, the term "state of health" of a battery means in the technical jargon of the sector a derived parameter that indicates the general condition of the battery and its performance capacity compared to the same new battery. This parameter is known by the English acronym "SOH" - State of Health - which also indicates the state of degradation and depletion of the battery. The state of health is therefore a figure of merit (i.e. a value used to characterize the performance of a device) of the state of the battery compared to its ideal conditions, in percentage terms. In fact, normally the state of health of a battery is 100% at the time of its production and decreases with its use over time.

The term "electric battery" will hereinafter be understood as a device capable of storing and releasing electric charge, in the first case by absorbing current and in the second by delivering it. In technical jargon, this type of battery is called secondary (or rechargeable), as opposed to primary batteries (which cannot be recharged).

In particular, it is known in the technical sector of reference to identify the battery also with the term "battery module", i.e. an electric charge accumulation device composed of a plurality of cells electrically connected to each other to obtain the desired voltage and / or electric capacity, as described in more detail below.

In the technical jargon of the sector the term "battery pack" is also known, i.e. an electric charge accumulation device comprising two or more of the aforementioned battery modules electrically connected to each other. For the sake of simplicity, in the present text reference will be made to an electric battery, but the present description is intended to be applicable also to a battery pack comprising several batteries and / or battery modules.

Initially, following their production, the cells that make up the electric batteries are identical to each other except for manufacturing tolerances or any manufacturing defects. With aging their characteristics decline and could do so in an uneven way, in which the cell with lower performance than the others influences the behavior of the entire electric battery. The battery could also have construction defects or be damaged for reasons related to its transport, assembly or use: these conditions could result in the damage of one or more of the cells that constitute it or in the risk of a short circuit of one of them, with a possible evolution in venting phenomena (gas leakage from the cell) or explosion / fire.

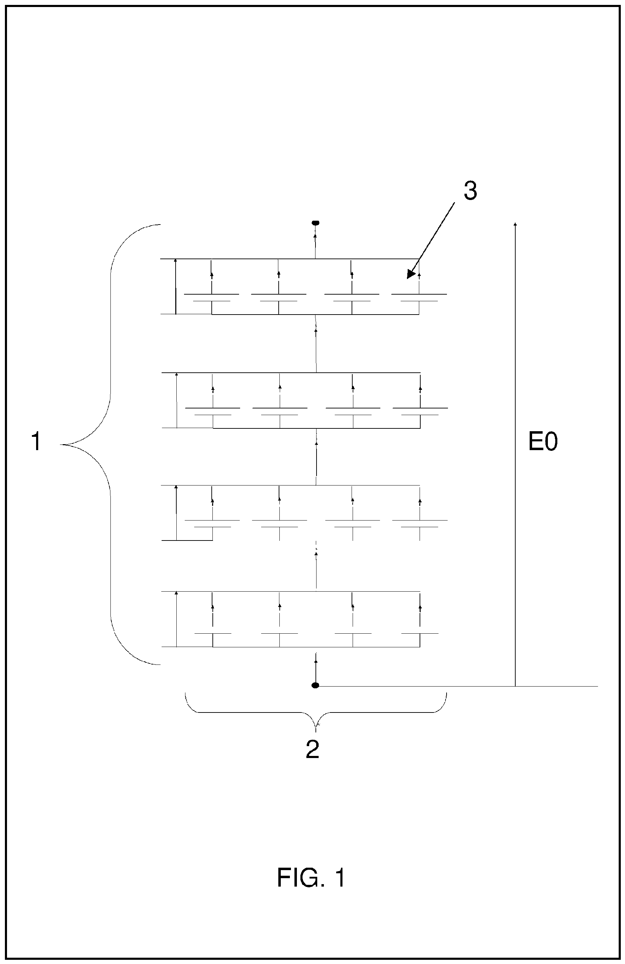

As mentioned, the performance and safety of a battery like that of Figure 1 are influenced by the characteristics of the most degraded cell or by the defects mentioned above: for this reason it is important to have a system that identifies the degradation through a numerical value and that can help both in diagnostics and in forecasting loss of performance.

In the Battery Technology Life Verification Test Manual formulated by relevant organizations such as the United States Department of Energy (DOE), the state of health (SOH) is defined as the rating of the remaining performance available for batteries in various wait, before battery performance can no longer meet operating requirements (i.e., before end of life). For this definition, the performances are evaluated in an overall way such as the maximum instantaneous charge-discharge power, available energy, energy efficiency of the batteries during the aging process, and at the same time it is specified that the SOH varies from 100% at the beginning of life up to at a minimum threshold value established for the particular application as the end of life of the battery.

In the technical sector of reference there are known devices and / or apparatus for managing batteries (the aforementioned BMS) which include at least one electronic device electrically connected to the battery and configured to manage the electric charging and discharging power, in order to force a operation of the battery in a safe operating area, i.e. obviating the risk of malfunctions due for example to overcurrents and / or overvoltages. Normally, an electric battery comprises a plurality of cells electrically connected to each other and connected to the aforementioned management device.

As is known, the battery management devices comprise at least one electronic memory in which an algorithm is saved which can implement a method for determining the state of health of the battery, in percentage or relative terms, giving for example a value between 0 and 1 , or between 0 and 100, where the value 1 (or 100) indicates the maximum health status (normally corresponding to the value at the time of production) and 0 indicates the minimum health status, i.e. end of battery life.

From the above it is evident that the state of health of a battery is not a quantity corresponding to a particular physical quantity, but is instead a general parameter of the conditions of the battery, for which there is no univocal method of determination.

Methods for determining the state of health of a battery are known which involve detecting at least one of the following parameters: internal resistance, internal impedance, internal conductance, capacity, voltage, self-discharge (phenomenon according to which internal chemical reactions reduce the stored charge battery without any connection between the electrodes or any external circuit), number of charge-discharge cycles, age of the battery, temperature of the battery during its previous uses, total energy charged and discharged.

In particular, it is known to carry out a test to determine the internal resistance and / or impedance of the battery, since, as is known, the increase in the internal resistance and / or impedance corresponds to a decrease in the state of health of the battery..

However, this type of method in practice has proved inconvenient as it requires the use of very sophisticated (and therefore expensive) instrumentation and to carry out very long and elaborate tests.

In order to calculate the health status of the battery, the designer of the battery management device defines an arbitrary weight for each parameter chosen from those listed above, to calculate the percentage value of the health status.

The methods for determining the state of health of a battery normally proposed in the technical sector of reference directly estimate the numerical values of the resistance or impedance of the battery. The direct estimation of these values involves the adoption and implementation of very complex measuring equipment or the subsequent calculation of these values is necessary. However, the a posteriori calculation implies the acceptance of a very high calculation error in the estimation of resistance and impedance, as these calculations involve the use of numerical derivatives, which as known, can be calculated numerically only as an approximation. In fact, the numerical derivative is a so-called 'poorly conditioned' operation, i.e. subject to very high calculation errors, consequently to minimize the calculation error it is necessary to use very short acquisition times of the quantities and the accuracy of the measurements must be very high.

Therefore, these methods for determining the state of health of a known type battery have proved to be not free from drawbacks in practice.

The main drawback lies in the fact that these methods, and consequently the management devices that implement them, are extremely expensive and complex.

A further drawback lies in the fact that the known methods are not very precise in the acquisition of the reference quantities to determine the state of health of the battery.

Furthermore, the known methods do not in any way provide for determining the state of health of the individual cells that make up the battery, but limit themselves to evaluating the aforementioned values of the entire battery, failing to detect where the problem is in the case if met one, unless there was a great computational effort.

A further drawback resides in the fact that the methods of the known type provide for calculations to be carried out by means of numerical methods which provide for derivatives. As is known, numerical calculations of derivatives are poorly conditioned, i.e. they are heavily affected by small fluctuations in the initial input data, resulting in fact very expensive from a computational point of view and not very reliable in the results obtained. An example of a known method, which has all the aforementioned drawbacks, is described in document US2015 / 260795A1, wherein such a method of determining the state of health of a first elementary cell of a battery comprises the steps of measuring the voltage across the cell at a plurality of times in a phase of cell charge or discharge between first and second state-of-charge level, and then detecting a crossing by the voltage of a predetermined specific value, corresponding to a predetermined specific charge value of the cell, the specific charge and voltage values corresponding to the coordinates of a crossing point of at least two curves representative of the variation of said voltage according to the charge contained in the cell, for different states of health of the cell.

PURPOSES OF THE INVENTION

The object of the present invention is to propose a method for determining the state of health of a battery which allows to satisfy, at least in part, the above requirements.

A further object of the invention is to provide a method for determining the state of health of a battery which allows to detect the state of health not only of the entire battery, but which is also capable of detecting the state of health of the batteries, strings of cells that make up the battery.

A further purpose of the invention is to provide a method for determining the state of health of a battery that uses cheap and easily available instrumentation, obviating the need to use complex and / or expensive instrumentation.

A further object of the present invention is to provide a method for determining the state of health of a battery which is computationally inexpensive.

A further object of the present invention is to provide a method for determining the state of health of a battery which does not use ill-conditioned numerical calculations.

A further object of the present invention is to provide a method for determining the state of health of a battery which is easy to implement.

A further object of the present invention is to provide a method for determining the state of health of a battery which is economically advantageous.

A further object of the present invention is to provide a method for determining the state of health of a battery which allows to carry out a diagnosis of the battery in its component parts.

A further object of the present invention is to provide a method for determining the state of health of a battery that uses tests that are simple to carry out, for example normal maintenance tests of the battery itself.

A further object of the present invention is to provide a method for determining the state of health of a battery which avoids measuring the internal resistances and impedances of the battery, thus obviating the need to use complex and expensive instrumentation.

A further object of the present invention is to provide a method for determining the state of health of a battery which is functionally completely reliable.

Another object of the present invention is to propose a method for determining the state of health of a battery which is an alternative and / or an improvement with respect to traditional solutions.

Another object of the present invention is to propose a method for determining the state of health of a battery which has an alternative and / or improved configuration, both in terms of construction and in terms of functionality, with respect to traditional solutions. All these purposes, both individually and in any combination thereof, and others which will result from the following description, are achieved, according to the invention, with a method for determining the state of health of a battery having the characteristics indicated in claim 1.

BRIEF DESCRIPTION OF THE FIGURES

The present invention is further described hereinafter in some of its preferred embodiments, given purely by way of non-limiting example with reference to the attached drawings, in which:

- figure 1 is a schematic view of a battery capable of implementing the method according to the invention;
- Figure 2 shows a schematic view of a series connection of three cell strings;
- Figure 3 shows a graph of the discharge and recharge phases provided for by the method object of the invention;
- Figure 4 shows a closed curve whose area is proportional to an energy dispersed by the battery;
- Figure 5 shows a graph of the no-load voltage of at least one string of battery cells, compared to the depth of discharge of the battery;
- Figure 6 shows a graph of the no-load voltage and the voltage across a string, measured as the depth of discharge varies in the charging and discharging phases, defining a closed curve;
- Figure 7 shows the graph in figure 6 performed for different strings of cells, suitably connected in series, with different capacities.

DETAILED DESCRIPTION OF THE INVENTION

An example of a battery on which the method according to the invention can be implemented has been identified as a whole with the reference 1 in the attached figures. The method in question finds advantageous use in the technical sector of the production and marketing of electric batteries, and in particular in the technical sector of the diagnostics of electric batteries, for any application.

The method for determining the state of health of a battery object of the present invention is suitably applicable substantially to any type of battery, in particular rechargeable, known in the technical jargon of the sector with the term "secondary", and in particular it is advantageously applicable to lithium-ion batteries.

Conveniently, the electric battery 1 in question comprises at least two strings 2 of cells 3 electrically connected to each other.

Obviously, the battery 1 may comprise any number of strings 2 of cells 3, without thereby departing from the scope of protection of this patent.

The term "electric battery" will hereinafter be understood as an electric accumulator consisting of several sub-components, such as in particular the "cells", i.e. the elementary portions capable of storing electrical energy, for example in the form of electrochemical energy or the like.

Conveniently, the cells 3 are electrically connected to each other in parallel defining the aforementioned strings 2. In other words, each string 2 comprises a plurality of cells 3 connected to each other in parallel. Furthermore, preferably, the battery 1 comprises at least two strings 2 connected to each other in series.

The battery 1 is equipped with an operating voltage Vc substantially equal to the sum of the partial voltages defined by the strings 2 electrically connected to each other in series, or by the partial voltages defined by the cells 3 electrically connected to each other in parallel, and therefore having the same voltage at the their heads, which define the strings 2.

Conveniently, the battery 1 also comprises at least one electronic control unit (not shown in the attached figures) electrically connected at least to said at least two strings 2.

Advantageously, the electronic control unit comprises a battery management device (known as the Battery Management System, BMS, in the technical jargon of the sector), electrically connected at least to the strings 2 of cells 3 and configured to receive electrical signals containing electrical measurements made on these strings 2.

According to the invention, the method in question comprises a plurality of operating steps, described in detail below.

With particular reference to the attached figure 1, the battery 1 has been represented by means of its equivalent circuit model, which shows each single group of cells electrically connected to each other in parallel.

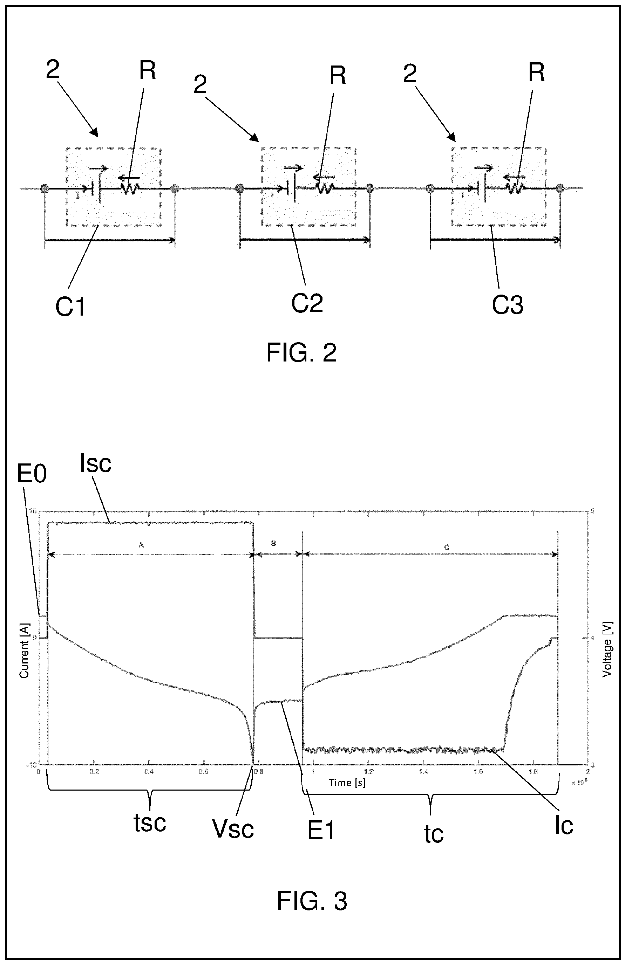

Figure 2 shows the equivalent circuit diagram of three strings 2 connected together in series.

For simplicity of illustration, the battery 1 is modeled as a group of strings in series with each other, in accordance with the attached figure 2, in which each string is intended to include a plurality of cells 3 connected to each other in parallel.

Preliminarily, the method comprises at least one step of setting up said battery 1 in a charged configuration with a substantially constant charging voltage E0 as shown in Figure 1. Advantageously, the charging voltage E0 is the same for all strings 2 of cells 3. E0 advantageously represents the no-load electromotive force in stationary conditions: the operating voltage Vc (discussed below) coincides with E0 when the current flowing in the circuit is zero and, preferably, the battery 1 is in a substantially stationary configuration.

In the following, reference will be made to the operating voltage Vc referred to a single cell 3 (or to a string 2 of cells 3 connected in parallel) of the battery 1 and, consequently, to the operating voltage Vc of each string 2 of cells 3 electrically connected in parallel. With particular reference to the attached figure 3, the method further provides for a discharge phase of the strings 2 of cells 3 of said battery 1 with a discharge current Isc, preferably substantially constant, in which said electronic control unit continuously measures a first voltage across said strings 2 and a discharge time tsc used to discharge said battery 1 with said discharge current Isc.

With the term "continuously" it will be understood in the following that the electronic control unit detects the aforementioned values during the entire discharge phase, associating a time value and a voltage value to each discharge current value Isc, for then use them in subsequent calculation phases described in detail below.

In particular, the discharge step provides for discharging at least one string 2 of cells 3 up to a discharge voltage Vsc. The value of the discharge voltage Vsc is advantageously a value higher than 0V, in order to preserve the integrity and storage capacity of the battery 1.

More in detail, the discharge voltage value Vsc reached by at least one string 2 is equivalent to a nominal end-of-discharge voltage value Vsc_nom, which is a known value given by the manufacturer. Advantageously, the achievement of the nominal end-of-discharge voltage value Vsc_nom depends on the capacity of each string 2 of cells 3 and / or greater internal resistance and / or impedance.

More in detail, during the discharge phase, the string 2 with lower capacity and / or greater resistance and / or internal impedance reaches said discharge voltage value Vsc equal to the rated end-of-discharge voltage value Vsc nom before other 2 strings with higher capacity. Following this achievement of the nominal end-of-discharge voltage value Vsc_nom, the discharge phase is interrupted for all strings 2.

Therefore, the strings 2 having a higher capacity, and / or lower internal resistance and / or impedance, have a discharge voltage Vsc greater than the nominal end-of-discharge voltage value Vsc_nom. Conveniently, the discharge of the strings 2 stops when at least one string has reached a minimum voltage value. In other words, when a damaged or degraded string in performance (and therefore with less capacity and / or greater resistance and / or internal impedance) is discharged, the other undamaged strings (with greater capacity and / or less resistance and / or internal impedance) stop the discharge, with a higher voltage Vc.

Conveniently, following the discharge phase, the method provides for a pause phase, in which said discharge current Isc is substantially canceled and in which said strings 2 stabilize said discharge voltages Vsc until respective stabilized no-load voltages E1 are reached.

In other words, during the pause phase, the strings 2 of cells 3 are advantageously empty, i.e. at substantially zero current, so that the operating voltage Vc, and in particular the discharge voltage Vsc, stabilizes on a constant value, defining the aforementioned stabilized no-load voltage value E1.

Advantageously, each string 2 of cells 3 defines a corresponding discharge voltage Vsc and therefore also a corresponding stabilized no-load voltage E1.

Preferably, following the stabilization of the operating voltage Vc on a constant value, i.e. the aforesaid stabilized no-load voltage value E1, a recharging phase takes place.

The method therefore provides for the phase of recharging said battery 1 with a recharging current Ic, in which said electronic control unit continuously measures a second voltage across said strings 2 and a recharging time tc used to recharge said battery 1 with said charging current Ic.

The term "continuously" must be understood in the following that the electronic control unit detects the aforementioned values during the entire charging phase, associating a time value and a voltage value to each charging current value Ic, for then use them in subsequent calculation phases described in detail below.

Advantageously, the recharging phase of the method according to the invention also provides for a constant voltage and variable current recharge. More clearly, the recharging phase provides for the recharging current Ic to be substantially constant for a first period of time and, preferably, also provides for the recharging current Ic to be gradually reduced so that the operating voltage of the cell Vc remains constant.

Obviously, the recharging phase of the method may provide for any type of recharge voltage and / or current known to the technician in the sector without thereby departing from the scope of protection of this patent.

The method therefore provides a first step of calculating an effective capacity value Ceff of each string 2 of cells 3 on the basis of said discharge current Isc, the value of said discharge time tsc, and / or the value of said current charge Ic and the value of said charging time tc and one value between the value of the discharge voltage Vsc and the value of the stabilized no-load voltages E1 and preferably on the basis of both values of the discharge Vsc and stabilized no-load voltages E1. The formulation of this effective capacity calculation will be described in more detail below.

Furthermore, the method provides for a second phase of calculation of a value proportional to an energy Ac dispersed during the discharge phase and the recharge phase, on the basis of said first voltage (measured during the discharge phase) and said second voltage (measured during the charging phase) at the ends of said cell 3 and / or said string 2, on the basis of said discharge current Isc, said discharge time tsc, said recharging current Ic, said recharging time tc and said effective capacity Ceff.

In other words, the second calculation step is carried out on the basis of said first voltage of said string 2, of said discharge current Isc, of said discharge time tsc, of said effective capacitance Ceff, and on the basis of said second voltage across said string 2, of said recharging current Ic, of said recharging time tc, of said effective capacity Ceff. Conveniently, said dispersed energy Ac is calculated in said second calculation phase as the area subtended between the operating voltage Vc as a depth of discharge DOD (Depth of Discharge, described in detail below) varies. In other words, the calculation of the aforementioned value proportional to the energy Ac is the calculation of a numerical integral over time of the voltage across the string 2 of cells 3, as described in detail below. Conveniently, the depth of discharge DOD is a value that indicates how much the battery has been discharged with respect to its nominal value. Similarly, the state of charge SOC (State of Charge) is the complementary quantity to the depth of discharge and indicates how much residual charge is still present accumulated in the battery.

The state of charge, SOC is defined as a function of the nominal capacity:

$$SOC = 1 - \frac{Q_e}{C_{nom}} = 1 - \frac{1}{3600} \frac{\int_0^t Isc\, dt}{C_{nom}};$$

in which Cnom is the nominal capacity of each cell 3 and Isc is the aforementioned discharge current of the discharge phase.

As mentioned above, the depth of discharge DOD is instead the complementary value to that of the SOC state of charge and is advantageously calculated as follows:

$$DOD(t) = 1 - SOC = \frac{1}{3600\, C_{nom}} \int_0^t i\, dt.$$

Advantageously, the discharge phase and the recharge phase are carried out in a quasi-steady state, i.e. assuming that the variations in electrical quantities over time are slow and therefore allow some electrical transients to be neglected.

In accordance with a first embodiment, the first phase of calculating said effective capacitance value Ceff and the second phase of calculating said value proportional to a dispersed energy Ac are carried out by the electronic control unit and in particular by the control device management of the electronic control unit, such as the BMS.

Otherwise, in accordance with a further embodiment, the first and second calculation phases are carried out by an external computing unit, such as a computer, be it a computer or the like.

The electronic control unit advantageously receives and stores the measurements of discharge current Isc, discharge time tsc, charging current Ic, charging time tc, discharge voltage Vsc of each string 2, stabilized no-load voltage E1 of each string 2.

In this way, an operator can take these measurements and process them with the aforementioned external calculation unit to carry out the first and second calculation phases.

Advantageously, the effective capacity Ceff of each string 2 of cells 3 is calculated according to the formula:

$$C_{eff} = \frac{Ah_{sc}}{DOD_f - DOD_i}$$

Where Ahsc is the electric charge delivered by battery 1 during the discharge phase, measured in amper hours (Ah), DODi is the depth of discharge of each string before the discharge phase and DODf is the depth of discharge at the end of the discharge phase. download.

Preferably, the calculation of the depth of discharge DOD is carried out on the basis of the value of the discharge voltage Vsc or by means of the stabilized no-load voltage value E1 of each string 2 of cells 3.

More in detail, the calculation of the depth of discharge DOD for the calculation of the effective capacity Ceff preferably involves the use of a database of values (for example in the form of a table and / or graph) of discharge voltages Vsc and / or values of stabilized no-load voltage E1 to which are associated corresponding values of state of charge SOC and / or corresponding values of depth of discharge DOD.

In other words, the first calculation step provides for receiving the measurement at least of the value of the discharge voltage Vsc and / or of the stabilized no-load voltage value E1 of each string 2 of cells 3; the first calculation phase also provides for comparing this measurement with the values saved in the database and therefore provides for selecting a value of a corresponding SOC state of charge and / or a corresponding DOD depth of discharge value.

Advantageously, said dispersed energy Ac is calculated at the end of both the discharge phase and the charge phase, according to the formula:

$$A_c = \int_{DOD_i}^{DOD_f} V_{ab}(t)\, DOD(t)\, dt$$

wherein:

$$DOD(t) = \frac{1}{3600\, C_{eff}} \int_{t_i}^{t} i\, dt$$

and in which in this case DODi is the depth of discharge at the beginning of said discharge phase and / or said recharge phase and in which DODf is the depth of discharge at the end of said discharge phase and / or said recharge phase .

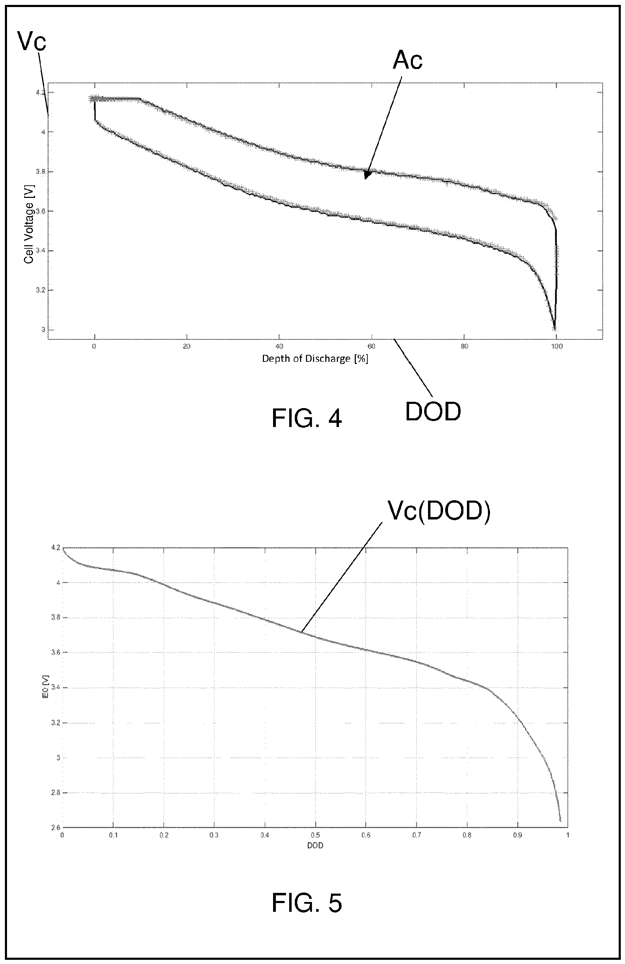

More in detail, the dispersed energy Ac can be calculated as the area subtended by the operating voltage curve Vc as the depth of discharge DOD varies, in accordance with the curve illustrated in the attached figure 5, and identified with the reference Vc (DOD) . In particular, Figure 4 shows the trend of the voltage as the depth of discharge varies at a fixed temperature T * of 25 ° C.

The trend of the voltage Vc also depends on the internal resistance of the battery, which, as known per se, increases with the aging of the battery 1.

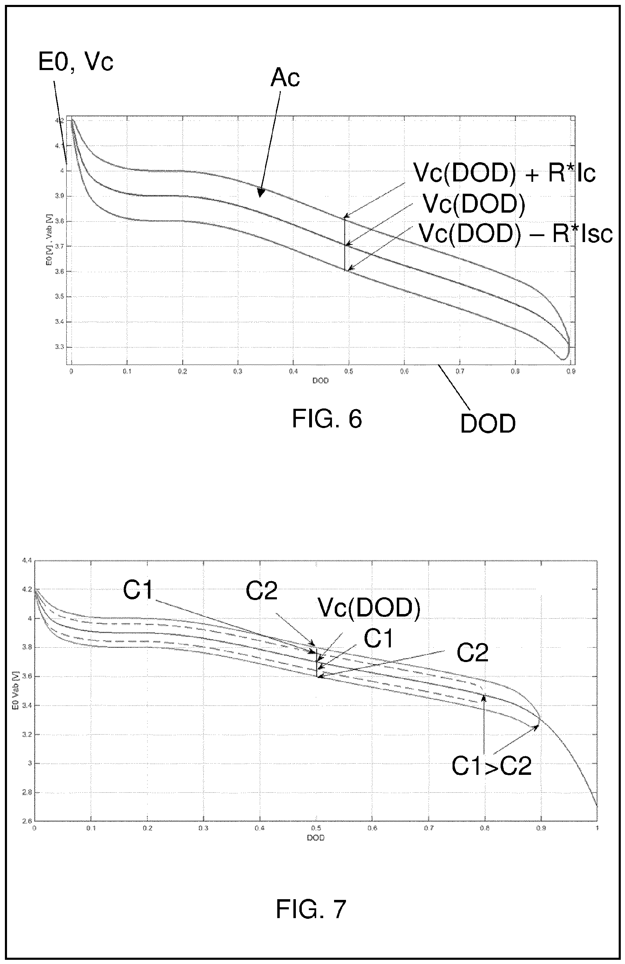

As shown in the attached figure 6, it is clearly visible how the construction of the closed curve from which it is possible to calculate the area is simply the curve in different operating conditions of battery charge and discharge 1.

More in detail, the curve defines an upper branch which coincides with the trend of the voltage Vc added to the voltage drop due to the charge current that crosses an internal resistance R of the string 2 of the battery 1. Similarly, the curve advantageously defines a lower branch which coincides with the trend of the voltage Vc with subtracted the voltage drop determined by the passage of the discharge current for the internal resistance R of the string 2.

Therefore, the larger the Ac area, the larger the internal resistance R of string 2 is, the more string 2 is therefore deteriorated. In other words, said dispersed energy Ac is proportional to the degradation of of the string 2 and therefore of the battery 1. Advantageously, the method according to the invention provides for numerical calculations that do not include derivatives. Otherwise, in fact, the method according to the invention provides for numerical calculations that include numerical integrals.

For example, Figure 2 shows three different cell strings, where a first string has C1 capability, a second string has C2 capability and a third string has C3 capability. As an example, we assume that the C2 capacitance of the second cell is greater than the C1 capacitance of the first cell and that the resistance of the first cell is greater than the resistance of the second cell, due to faster aging.

The attached figure 7 shows the voltage curve Vc as the depth of discharge DOD varies for the first capacity cell C1 and for the second capacity cell C2, for which the discharge and recharge phases are performed, starting from a initial voltage E0 the same for all, and therefore that they start from the same SOC state of charge and from the same initial DOD depth of discharge.

If the cells have different capacities and internal resistances and the same Vc trend (SOC), the discharge will be interrupted by the one with lower capacity or with higher internal resistance and the final DOD values of the single groups of the whole will be inversely proportional to each other. those of the actual capacities (greater for smaller capacities) as indicated in figure 7.

In particular, Figure 7 identifies the terminal portion of the dashed curve which is clearly shorter in the case of the first cell with a capacity C2 greater than the capacity C1 of the second cell. Advantageously, the area of figure 7 is smaller for the cell with higher capacity and / or resistance and / or lower impedance.

Advantageously, the value of the dispersed energy Ac is inversely proportional to the effective capacity of the subgroup and proportional to its series resistance: it follows that the dispersed energy Ac associated with a cell that works in better conditions than another (higher capacity and resistance lower) will be lower than the dispersed anergy associated with that of the latter.

Advantageously, the present invention also furthermore relates to a device for verifying the state of health of a battery, configured to be electrically connected to a device for managing at least one battery (preferably of the type described above), programmed to carry out the operating steps for implementing the method for determining the state of health of a battery, described above and also the subject of the present invention.

Preferably, the device in question is configured to carry out at least the charging step and the discharging step of the battery 1 in a controlled manner. Preferably, moreover, the device comprises means for detecting the aforementioned electrical quantities and at least one electronic control unit configured to receive and process these quantities, in accordance with the operating steps of the method which is also the subject of the present invention.

Conveniently, the method therefore provides at least one step for evaluating at least one degradation coefficient Fdeg of each said string 2 of said battery 1 on the basis of at least the proportional value of said dispersed energy Ac. The calculation of this degradation coefficient will be described in detail below. The degradation coefficient Fdeg indicates with a numerical value the aging of the battery, i.e. the inability of the individual strings 2 to store electric charge and / or provide power.

In order to understand the state of health of the battery 1, the method therefore provides at least one step for comparing said degradation coefficient Fdeg with a maximum degradation value Fmax to define the state of health of said battery.

In this way, the method according to the invention makes it possible to carry out the assessment of the state of health of the battery in a simple and economical way. In particular, the method according to the invention allows you to calculate the state of health of the battery by carrying out only the aforementioned discharge and recharge phases, which are in themselves well known to the skilled in the art and cheap to carry out.

Conveniently, the operating steps described above are carried out for each string 2 of cells 3, since the electronic control unit is electrically connected to each string 2 and receives its measurements during each discharge and recharge phase.

The method according to the invention therefore allows to obtain the state of health in a quick and simple way not only of the battery 1 but also of each string 2 of cells 3.

Numerically characterizing the degradation of the individual strings 2 of cells 3 of a battery 1 allows to identify the particular group of cells 3 (i.e. the particular string 2) which could have a future malfunction due to their anomalous deterioration or a construction defect. or damage, replacing them before this happens, which if not done would compromise the functionality and safety of the battery 1.

Furthermore, as described in more detail below, the method according to the invention allows to establish a criterion to be used to define the conditions of withdrawal of the entire battery 1 and its possible use, for example, in a less demanding application (in jargon, "Second Life") or for the final recycling at the end of life (optimization of the management of exhausted batteries).

Advantageously, the method according to the invention comprises at least a third phase of calculating an energy efficiency value $\eta$ of the discharge phase and of the recharge phase.

Advantageously, the energy yield is calculated according to the formula:

$$\eta_i = \frac{\int_0^{T_{sc}} V_c\, i_{sc}\, dt}{\int_0^{T_c} V_c\, i_c\, dt}\;;$$

where Vc is the operating voltage of each string 2, Isc is the discharge current measured during the discharge phase and Ic is the recharge current measured during the charging phase, Tsc is the discharge time measured during the discharge phase and Tc is the charging time measured during the charging phase.

Conveniently, the evaluation phase is carried out by the electronic control unit, programmed to receive the measurements made during the discharge phase and the recharge phase and process them to obtain the aforementioned degradation coefficient Fdeg.

Otherwise, in accordance with a further embodiment of the present invention, the evaluation phase is carried out by an external unit (such as for example a computer, in particular a PC) which receives the measurements obtained during the discharge and recharge phases and processes them. to obtain the aforementioned degradation coefficient Fdeg.

Conveniently, furthermore, said evaluation step provides for calculating said degradation coefficient Fdeg on the basis of the value of said effective capacitance Ceff of each string 2 of cells 3 and preferably also on the basis of the value of the energy efficiency η.

In accordance with a preferential embodiment of the present invention, the evaluation step provides for performing a ratio between said value of said effective capacity Ceff and / or value of said energy efficiency η and / or value of said dispersed energy Ac with the respective nominal values Cnom, ηnom, Acnom.

Normally, the ratings are supplier nameplate values chosen by the designer.

More in detail, the battery designer chooses the cell model 3 with which to build it and the way to assemble it (defining the number of cells to be connected in parallel to constitute the strings 2 and the number of these to be connected in series) based on the performance required by the particular application and the technical characteristics of the cell. In general, the manufacturer provides the effective capacity of the cell at various discharge regimes, the voltage curves Vc corresponding to these regimes, the rated capacity and other indications.

The designer decides, on the basis of the application, which is the maximum acceptable degradation value and the maximum acceptable degradation coefficient Fmax of the battery performance and transforms this value into the reduction of the effective capacity of the single cell or group of cells and increase of the internal resistance R of the cell. Therefore, on the basis of the data supplied by the manufacturer and these considerations, the numerical values of the nominal quantities are defined.

In other words, the method according to the invention advantageously uses three quantities, evaluated during the operational phases of discharge and recharge, which act as indicators for the construction of the degradation coefficient Fdeg, which represents a combination of it: the effective capacity of each string 2 of 3 Ceff cells, the efficiency on the discharge and recharge phases c, and the dispersed energy Ac (which, as described in detail below, is calculated as the area Ac subtended by the closed curve DOD-Vc) obtained during the phases of discharge and recharge.

Once the numerical values of the aforementioned three quantities used for the construction of the degradation coefficient Fdeg have been calculated, they are compared to the corresponding nominal and / or end-of-life values chosen for the specific application.

Advantageously, the first calculation phase, the second calculation phase and the third calculation phase of the method according to the invention suitably provide for calculating by numerically integrating the trend of the voltage of each string 2 of cells 3, in particular as a function of time. of discharge tsc and / or of the recharge time tc and / or of the discharge current Isc and / or of the recharge current Ic.

In fact, numerical integration is a well-conditioned operation (i.e. the result of numerical integration is less influenced by measurement errors, than for example the numerical derivation operation), it follows that in order to implement the method according to the invention Sophisticated experimental equipment is required.

Conveniently, said evaluation step provides for calculating said degradation coefficient Fdeg by means of the formula:

$$F_{deg} = P_1 \left(1 - \frac{C_{eff}}{C_{nom}}\right) + P_2 \left(1 - \frac{\eta}{\eta_{nom}}\right) + P_3 \left(1 - \frac{A_{cnom}}{A_c}\right);$$

where P1, P2, P3 are variable coefficients.

More in detail, the variable coefficients P1, P2, P3 are advantageously decided by the designer based on the needs of the application, in which P1 is linked to the residual capacity (available energy), P2 to internal losses (resistance and deliverable power) and P3 both ability and endurance.

Advantageously, said comparison step provides for comparing said degradation coefficient Fdeg with a null value, and identifying the state of health of said battery 1.

More in detail, if the degradation coefficient Fdeg is less than zero, the string 2 of cells 3 is in a better state of health than a nominal state of health; if the degradation coefficient Fdeg is greater than zero, the string 2 of cells 3 is in a worse state of health than the nominal state of health.

Conveniently, furthermore, said comparison step provides for comparing said degradation coefficient Fdeg with said maximum degradation value Fmax. More in detail, if the degradation coefficient Fdeg is between zero and the maximum coefficient Fmax, string 2 is in an acceptable and operational state of health; if the degradation coefficient

Fdeg is greater than or equal to the maximum coefficient Fmax it is in an inoperative and unacceptable state of health and therefore the battery 1 is destined to be withdrawn. Advantageously, said discharge step and said recharge step provide for measuring the aforementioned operating voltage Vc of each string 2 of cells 3 and a depth of discharge DOD on the basis of the value of said effective capacitance Ceff.

Operationally, initially the string 2 of cells 3 of battery 1 is at rest, with the voltage across it equal to the electromotive force (FEM) and coinciding with the maximum working voltage E0 = Vcmax (which corresponds to a maximum state of charge SOC = 1). Subsequently, the string 2 of cells 3 is discharged, during the discharge phase according to the method, with a constant current preferably equal to about half the value of the rated capacity (0.5 C) until it reaches Vsc, i.e. the minimum working voltage (Vcmax and Vsc are data normally supplied by the manufacturer).

Subsequently, the charging phase follows, preferably at 0.5 C, until the Vcmax value is reached again, then the charging phase is appropriately continued by progressively reducing the charging current Ic in order to keep the cell voltage constant (i.e. a charge constant voltage).

Operationally, when the recharging current Ic falls below a minimum predetermined value (indicated by the manufacturer or by the standards) associated with the fully charged cell condition, the recharging phase is interrupted.

From what has been said it is clear that the method for determining the state of health of a battery, according to the invention, is particularly advantageous in that:

- allows you to detect the state of health not only of the entire battery, but is also able to detect the state of health of the strings of cells that make up the battery itself;
- uses cheap and easily available equipment, obviating the need to use complex and / or expensive equipment;
- it is not computationally expensive, i.e. obviates the need to use ill-conditioned numerical calculations;
- it is easy to implement;
- allows you to carry out a diagnostic of the battery in the parts that compose it;
- uses tests that are simple to carry out, in particular normal maintenance tests for the battery itself for discharging and recharging the battery;
- avoids taking measurements of the internal resistances and impedances of the battery, thus obviating the need to use complex and expensive instrumentation;
- it is functionally completely reliable;
- it is an alternative and better than traditional solutions;
- has an improved configuration, both in constructive and functional terms, compared to traditional solutions.

The present invention has been illustrated and described in a preferred embodiment thereof, but it is understood that executive variations may be applied to it in practice, said variations being part of the present invention if they do not contradict the appended claims (i.e. if they comprise at least all features of at least one appended independent claim).

**Claims**

1. Method for determining the state of health of at least one electric battery, wherein said battery (1) comprises at least two strings (2) of cells (3) electrically connected to each other and at least one electronic control unit electrically connected at least to said at least two strings (2), in which said method comprises at least the following operating steps:

   - a step of preparing said battery (1) in a charged configuration with a substantially constant charging voltage (E0);
   - a discharge phase of said strings (2) of said cells (3) of said battery (1) with a discharge current (Isc), preferably substantially constant, in which said electronic control unit continuously measures a first voltage at the ends of said strings (2) and a discharge time (tsc) used to discharge said battery (1) with said discharge current (Isc) until at least one of said strings (2) reaches a voltage discharge (Vsc);
   - a pause phase, in which said discharge current (Isc) is substantially canceled and in which said strings (2) stabilize said discharge voltages (Vsc) until respective stabilized no-load voltages (E1) are reached;
   - a phase of recharging said battery (1) with a recharging current (Ic), in which said electronic control unit continuously measures a second voltage across said strings (2) and a recharging time (tc) used for recharging said battery (1) with said recharging current;
   - a first step of calculating an effective capacity value (Ceff) of each string (2) of cells (3) based on the value of said discharge current (Isc), the value of said discharge time (tsc), and one of the value of said discharge voltage (Vsc) and said stabilized no-load voltages (E1) according to the following formula:

$$C_{eff} = \frac{Ah_{sc}}{DOD_f - DOD_i}$$

Where $Ah_{sc}$ is the electric charge delivered by battery 1 during the discharge phase, measured in ampere hours (Ah) and calculated based on the value of said discharge current (Isc) and the value of said discharge time (tsc); DODi is the depth of discharge of each string before the discharge phase and DODf is the depth of discharge at the end of the discharge phase; and

the calculation of the depth of discharge DOD is carried out based on the value of the discharge voltage (Vsc) or by means of the stabilized no-load voltage value (E1);
further comprising

- a second phase of calculation of a value proportional to an energy (Ac) dispersed during the discharge phase and the recharge phase, based on:

said first voltage of said string (2), said discharge current (Isc), the value of said discharge time (tsc) and said effective capacitance (Ceff);
said second voltage across said string (2), said recharging current (Ic), the value of said recharging time (tc) and said effective capacity (Ceff)

- at least one step of evaluating at least one degradation coefficient (Fdeg) of each said string (2) of said battery (1) based on at least of the proportional value of said dispersed energy (Ac);
- at least one step of comparing said degradation coefficient (Fdeg) with a maximum degradation value (Fmax) to define the state of health of said battery.

2. Method according to claim 1, comprising at least a third calculation phase, in which said electronic control unit calculates at least one energy efficiency value ($\eta$) of the discharge phase and of the recharge phase and in that said evaluation step provides for calculating said degradation coefficient (Fdeg) based on the value of said energy efficiency ($\eta$).

3. Method according to claim 2, wherein said evaluation step provides for performing a ratio between said value of said effective capacity (Ceff) and / or value of said energy efficiency ($\eta$) and / or value of said dispersed energy (Ac) with the respective nominal values (Cnom, $\eta$nom, Acnom).

4. Method according to claim 3, wherein said evaluation step provides for calculating said degradation coefficient by means of the formula:

$$F_{deg} = P_1\left(1 - \frac{C_{eff}}{C_{nom}}\right) + P_2\left(1 - \frac{\eta}{\eta_{nom}}\right) + P_3\left(1 - \frac{A_{cnom}}{A_c}\right);$$

where P1, P2, P3 are variable coefficients.

5. Method according to claim 4, wherein said comparison step provides for comparing said degradation coefficient (Fdeg) with a null value, and identifying the state of health of said battery, in which if the degradation coefficient (Fdeg) is less than zero, the string (2) of cells (3) is in better health than nominal health; if the degradation coefficient (Fdeg) is greater than zero, the string (2) of cells (3) is in a worse health state than the nominal health state.

6. Method according to claim 5, wherein said comparison step provides for comparing said degradation coefficient (Fdeg) with said maximum degradation value (Fmax), wherein if the degradation coefficient (Fdeg) is between zero and the maximum coefficient (Fmax) the string (2) is in an acceptable and operational state of health; if the degradation coefficient (Fdeg) is greater than or equal to the maximum coefficient (Fmax) it is in an inoperative and unacceptable state of health.

7. Method according to one or more of claims 2 to 6, wherein said discharge phase and said recharge phase provide for measuring an operating voltage (Vc) of each string (2) of cells (3) and a depth discharge (DOD) on the basis of the value of said effective capacity (Ceff);

and by the fact that said dispersed energy (Ac) is calculated in said third calculation phase as the area subtended between the operating voltage (Vc) as the said depth of discharge (DOD) varies.

8. Method according to claim 7, wherein the cells (3) of each string (2) are electrically connected to each other in parallel, said strings being electrically connected to each other in series so that said operating voltage (Vc) is substantially equal to the sum of the voltage of each string (2).

9. Method according to claim 7 or 8, wherein the calculation of said value proportional to the energy (Ac) is the calculation of a numerical integral over time of said voltage across said string (2) of cells (3).

10. Method according to claim 9, wherein said dispersed energy Ac is calculated according to the formula:

$$A_c = \int_{DOD_i}^{DOD_f} V_{ab}(t)\, DOD(t)\, dt$$

wherein:

$$DOD(t) = \frac{1}{3600\, C_{eff}} \int_{t_i}^{t} i\, dt$$

and in which DODi is the depth of discharge at the beginning of said discharge phase and / or said recharge phase and in which DODf is the depth of discharge at the end of said discharge phase and / or said recharge phase.

11. Method according to one or more of claims 2 to 10, wherein said dispersed energy (Ac) is proportional to the degradation of said battery (1).

12. Method according to one or more of the preceding claims, wherein it provides numerical calculations which do not include derivatives.

13. Device for verifying the health status of a battery, configured to be electrically connected to a management device of at least one battery, such a device for verifying the health status of a battery comprising means for detecting electrical quantities of claim 1 and at least an electronic control unit configured to receive said electrical quantities and programmed to carry out the operational steps to implement the method for determining the health status of a battery according to one or more than the previous claims.

**Patentansprüche**

1. Verfahren zum Bestimmen des Gesundheitszustands von mindestens einer elektrischen Batterie, wobei die Batterie (1) mindestens zwei Stränge (2) von Zellen (3) umfasst, die elektrisch miteinander verbunden sind, und mindestens eine elektronische Steuereinheit, die elektrisch mit mindestens den mindestens zwei Strängen (2) verbunden ist, wobei das Verfahren mindestens die folgenden Betriebsschritte umfasst:

- einen Schritt zum Vorbereiten der Batterie (1) in einer geladenen Konfiguration mit einer im Wesentlichen konstanten Ladespannung (E0);
- eine Entlade-Phase der Stränge (2) der Zellen (3) der Batterie (1) mit einem vorzugsweise im Wesentlichen konstanten Entlade-Strom (Isc), in der die elektronische Steuereinheit kontinuierlich eine erste Spannung an den Enden der Stränge (2) und eine Entlade-Zeit (tsc) misst, die zum Entladen der Batterie (1) mit dem Entlade-Strom (Isc) verwendet wird, bis mindestens einer der Stränge (2) eine Entlade-Spannung (Vsc) erreicht;
- eine Pausenphase, in der der Entlade-Strom (Isc) im Wesentlichen aufgehoben wird und in der die Stränge (2) die Entlade-Spannungen (Vsc) stabilisieren, bis jeweilige stabilisierte Leerlaufspannungen (E1) erreicht sind;
- eine Phase des Wiederaufladens der Batterie (1) mit einem Wiederaufladestrom (Ic), in der die elektronische Steuereinheit kontinuierlich eine zweite Spannung über den Strängen (2) und eine zum Wiederaufladen der Batterie (1) mit dem Wiederaufladestrom verwendete Wiederaufladezeit (tc) misst;
- einen ersten Schritt zum Berechnen eines effektiven Kapazitätswerts (Ceff) jedes Strangs (2) von Zellen (3) auf der Grundlage des Werts des Entlade-Stroms (Isc) und des Werts der Entlade-Zeit (tsc) und von einem der Werte der Entlade-Spannung (Vsc) und des Werts der stabilisierten Leerlaufspannungen (E1), nach folgender Formel:

$$C_{eff} = \frac{Ah_{sc}}{DOD_f - DOD_i}$$

wo Ahsc die von der Batterie 1 während der Entlade-Phase gelieferte elektrische Ladung ist, die in Amperestunden (Ah) gemessen wird und sich auf dem Wert des Entlade-Stroms (Isc) basiert und nach dem Wert der Entlade-Zeit (tsc) berechnet wird; DODi ist die Entlade-Tiefe jedes Strangs vor der Entlade-Phase und DODf ist die Entlade-Tiefe am Ende der Entlade-Phase; und die Berechnung der Entlade-Tiefe (DOD) auf der Grundlage des Wertes der Entlade-Spannung (Vsc) oder des Wertes der stabilisierten Leerlaufspannung (E1) durchgeführt wird, ferner umfassend

- eine zweite Phase des Berechnens eines Wertes, der proportional zu einer während der Entlade-Phase und der Wiederaufladephase abgegebenen Energie (Ac) ist, basierend auf:

  der ersten Spannung des Strangs (2), des Entlade-Stroms (Isc), des Werts der Entlade-Zeit (tsc) und der effektiven Kapazität (Ceff);
  der zweiten Spannung über dem Strang (2) und des Wiederaufladestroms (Ic), dem Wert der Wiederauladezeit (tc) und der effektiven Kapazität (Ceff)

- mindestens einen Schritt zum Auswerten von mindestens einem Degradationskoeffizienten (Fdeg) jedes Strangs (2) der Batterie (1) auf der Grundlage von mindestens dem proportionalen Wert der abgegebenen Energie (Ac);
- mindestens einen Schritt zum Vergleichen des Degradationskoeffizienten (Fdeg) mit einem maximalen Degradationswert (Fmax), um den Gesundheitszustand der Batterie zu bestimmen.

2. Verfahren nach Anspruch 1, umfassend mindestens eine dritte Berechnungsphase, in der die elektronische Steuereinheit mindestens einen Energieeffizienzwert ($\eta$) der Entlade-Phase und der Wiederaufladephase berechnet, und dass der Bewertungsschritt die Berechnung des Degradationskoeffizienten (Fdeg) auf der Grundlage des Werts der Energieeffizienz ($\eta$) vorsieht.

3. Verfahren nach Anspruch 2, wobei der Bewertungsschritt die Erstellung eines Vergleichs zwischen dem Wert der effektiven Kapazität (Ceff) und/oder dem Wert der Energieeffizienz ($\eta$) und/oder dem Wert der abgegebenen Energie (Ac) mit den jeweiligen Nennwerten (Cnom, $\eta$nom, Acnom) vorsieht.

4. Verfahren nach Anspruch 3, wobei der Bewertungsschritt die Berechnung des Degradationskoeffizienten mittels der folgenden Formel

$$F_{deg} = P_1\left(1 - \frac{c_{eff}}{c_{nom}}\right) + P_2\left(1 - \frac{\eta}{\eta_{nom}}\right) + P_3\left(1 - \frac{A_{cnom}}{A_c}\right);$$

vorsieht, wobei P1, P2, P3 variable Koeffizienten sind.

5. Verfahren nach Anspruch 4, wobei der Vergleichsschritt das Vergleichen des Degradationskoeffizienten (Fdeg) mit einem Nullwert und das Ermitteln des Gesundheitszustands der Batterie vorsieht, wobei, wenn der Degradationskoeffizient (Fdeg) kleiner als Null ist, hat der Strang (2) von Zellen (3) einen besseren Gesundheitszustand als den nominalen Gesundheitszustand; wenn der Degradationskoeffizient (Fdeg) größer als Null ist, hat der Strang (2) von Zellen (3) einen schlechteren Gesundheitszustand als den nominalen Gesundheitszustand.

6. Verfahren nach Anspruch 5, wobei der Vergleichsschritt das Vergleichen des Degradationskoeffizienten (Fdeg) mit dem maximalen Degradationswert (Fmax) vorsieht, wobei, wenn der Degradationskoeffizient (Fdeg) zwischen Null und dem maximalen Koeffizienten (Fmax) liegt, befindet sich der Strang (2) in einem akzeptablen und betriebsbereiten Gesundheitszustand; wenn der Degradationskoeffizient (Fdeg) größer oder gleich dem maximalen Koeffizienten (Fmax) ist, befindet er sich in einem nicht betriebsbereiten und nicht akzeptablen Gesundheitszustand.

7. Verfahren nach einem oder mehreren der Ansprüche 2 bis 6, wobei die Entlade-Phase und die Wiederaufladephase eine Betriebsspannung (Vc) jedes Strangs (2) von Zellen (3) und eine Tiefenentladung (DOD) auf der Grundlage des Werts der effektiven Kapazität (Ceff) messen;
und wobei die abgegebene Energie (Ac) in der dritten Berechnungsphase als der Bereich berechnet wird, die sich zwischen der Betriebsspannung (Vc) und der sich ändernden Entlade-Tiefe (DOD) erstreckt.

8. Verfahren nach Anspruch 7, wobei die Zellen (3) jedes Strangs (2) elektrisch parallel miteinander verbunden sind, wobei die Stränge elektrisch in Reihe miteinander verbunden sind, so dass die Betriebsspannung (Vc) im Wesentlichen gleich der Summe der Spannung jedes Strangs (2) ist.

9. Verfahren nach Anspruch 7 oder 8, **dadurch gekennzeichnet, dass** die Berechnung des der Energie (Ac) proportionalen Wertes die Berechnung eines numerischen Integrals der Spannung über des Strangs (2) von Zellen (3) über die Zeit ist.

10. Verfahren nach Anspruch 9, wobei die abgegebene Energie Ac gemäß der Formel:

$$A_c = \int DOD_f \, V_{ab}(t) DOD(t) dt$$

$DOD_i$ berechnet wird, wo

$$DOD(t) = \frac{1}{3600 \, C_{eff}} \int_{t_i}^{t} i \, dt$$

und wo DODi die Entlade-Tiefe zu Beginn der Entlade-Phase und/oder der Wiederaufladephase ist und wo DODf die Entlade-Tiefe am Ende der Entlade-Phase und/oder der Wiederaufladephase ist.

11. Verfahren nach einem oder mehreren der Ansprüche 2 bis 10, wobei die abgegebene Energie (Ac) proportional zur Degradation der Batterie (1) ist.

12. Verfahren nach einem oder mehreren der vorhergehenden Ansprüche, wobei es numerische Berechnungen liefert, die keine Ableitungen enthalten.

13. Vorrichtung zur Bestimmung des Gesundheitszustands einer Batterie, konfiguriert für den elektrischen Anschluss an eine Vorrichtung zur Verwaltung mindestens einer Batterie, wobei eine solche Vorrichtung zur Bestimmung des Gesundheitszustands einer Batterie Mittel zur Erfassung elektrischer Größen nach Anspruch 1 und mindestens eine elektronische Steuereinheit umfasst, die so konfiguriert ist, dass sie die elektrischen Größen empfängt und so programmiert ist, dass sie die Betriebsschritte zur Ausführung des Verfahrens zur Bestimmung des Gesundheitszustands einer Batterie gemäß einem oder mehreren der vorhergehenden Ansprüche ausführt.

## Revendications

1. Procédé de détermination de l'état de santé d'au moins une batterie électrique, dans lequel ladite batterie (1) comprend au moins deux chaînes (2) de cellules (3) connectées électriquement entre elles et au moins une unité électronique de commande connectée électriquement au moins auxdites au moins deux chaînes (2), dans lesquelles ledit procédé comprend au moins les étapes opératoires suivantes :

   - une étape de préparation de ladite batterie (1) dans une configuration chargée avec une tension de charge (E0) sensiblement constante ;
   - une phase de décharge desdites chaînes (2) desdites cellules (3) de ladite batterie (1) avec un courant de décharge (Isc), de préférence sensiblement constant, dans laquelle ladite unité électronique de commande mesure en continu une première tension aux extrémités des dites chaînes (2) et un temps de décharge (tsc) utilisé pour décharger ladite batterie (1) avec ledit courant de décharge (Isc) jusqu'à ce qu'au moins une desdites chaînes (2) atteigne une décharge de tension (Vsc) ;
- une phase de pause, dans laquelle ledit courant de décharge (Isc) est sensiblement annulé et dans laquelle lesdites chaînes (2) stabilisent lesdites tensions de décharge (Vsc) jusqu'à ce que des tensions à vide stabilisées respectives (E1) soient atteintes ;
- une phase de recharge de ladite batterie (1) avec un courant de recharge (Ic), dans laquelle ladite unité électronique de commande mesure en continu une deuxième tension à travers desdites chaînes (2) et un temps de recharge (tc) utilisé pour recharger ladite batterie (1), avec ledit courant de recharge ;
- une première étape de calcul d'une valeur de capacité efficace (Ceff) de chaque chaîne (2) de cellules (3) sur la base de la valeur dudit courant de décharge (Isc), de la valeur dudit temps de décharge (tsc) et d'une des valeurs de ladite tension de décharge (Vsc) et desdites tensions à vide stabilisées (E1) selon la formule qui suit :

$$C_{eff} = \frac{Ah_{sc}}{DOD_f - DOD_i}$$

où $Ah_{sc}$ est la charge électrique fournie par la batterie 1 pendant la phase de décharge, mesurée en ampère heures (Ah) et calculée en base à la valeur dudit courant de décharge (Isc) et à la valeur dudit temps de décharge (tsc); $DOD_i$ est la profondeur de décharge de chaque chaîne avant la phase de décharge et $DOD_f$ est la profondeur de décharge à la fin de la phase de décharge ; et le calcul de la profondeur de décharge (DOD) est effectué sur la base de la valeur de la tension de décharge (Vsc) ou par la valeur de tension à vide stabilisée (E1), comprenant en outre
- une deuxième phase de calcul d'une valeur proportionnelle à une énergie (Ac) dispersée pendant la phase de décharge et la phase de recharge, basée sur :

   ladite première tension de ladite chaîne (2), le dit courant de décharge (Isc), la valeur dudit temps de décharge (tsc) et ladite capacité effective (Ceff);
   ladite deuxième tension à travers ladite chaîne (2), ledit courant de recharge (Ic), la valeur dudit temps de recharge (tc) et ladite capacité effective (Ceff)

- au moins une étape d'évaluation d'au moins un coefficient de dégradation (Fdeg) de chaque dite chaîne (2) de ladite batterie (1) sur la base au moins de la valeur proportionnelle de ladite énergie dispersée (Ac);
- au moins une étape de comparaison dudit coefficient de dégradation (Fdeg) avec une valeur maximale de dégradation (Fmax) pour définir l'état de santé de ladite batterie.

2. Procédé selon la revendication 1, comprenant au moins une troisième phase de calcul, dans laquelle ladite unité électronique de commande calcule au moins une valeur d'efficacité énergétique ($\eta$) de la phase de décharge et de la phase de recharge et en ce que ladite étape d'évaluation prévoit le calcul dudit coefficient de dégradation (Fdeg) sur la base de la valeur de ladite efficacité énergétique ($\eta$).

3. Procédé selon la revendication 2, dans lequel ladite étape d'évaluation prévoit d'effectuer un rapport entre ladite valeur de ladite capacité effective (Ceff) et/ou la valeur de ladite efficacité énergétique ($\eta$) et/ou la valeur de ladite énergie dispersée (Ac) avec les valeurs nominales respectives (Cnom, $\eta$nom, Acnom).

4. Procédé selon la revendication 3, dans lequel ladite étape d'évaluation prévoit de calculer ledit coefficient de dégradation au moyen de la formule :

$$F_{deg} = P_1 \left(1 - \frac{c_{eff}}{c_{nom}}\right) + P_2 \left(1 - \frac{\eta}{\eta_{nom}}\right) + P_3 \left(1 - \frac{A_{cnom}}{A_c}\right);$$

où P1, P2, P3 sont des coefficients variables.

5. Procédé selon la revendication 4, dans lequel ladite étape de comparaison prévoit de comparer ledit coefficient de dégradation (Fdeg) avec une valeur nulle, et d'identifier l'état de santé de ladite batterie, dans lequel si le coefficient de dégradation (Fdeg) est inférieur à zéro, la chaîne (2) de cellules (3) est en meilleure santé que la santé nominale ; si le coefficient de dégradation (Fdeg) est supérieur à zéro, la chaîne (2) de cellules (3) est dans un état de santé moins bon que l'état de santé nominal.

6. Procédé selon la revendication 5, dans lequel ladite étape de comparaison prévoit de comparer ledit coefficient de dégradation (Fdeg) avec ladite valeur de dégradation maximale (Fmax), dans lequel si le coefficient de dégradation (Fdeg) est compris entre zéro et le coefficient maximum (Fmax), la chaîne (2) est dans un état de santé acceptable et opérationnel ;
si le coefficient de dégradation (Fdeg) est supérieur ou égal au coefficient maximum (Fmax) il est dans un état de santé inopérant et inacceptable.

7. Procédé selon une ou plusieurs des revendications 2 à 6, dans lequel ladite phase de décharge et ladite phase de recharge prévoient de mesurer une tension de fonctionnement (Vc) de chaque chaîne (2) de cellules (3) et une décharge en profondeur (DOD) sur la base de la valeur de ladite capacité effective (Ceff) ;
et par le fait que ladite énergie dispersée (Ac) est calculée dans ladite troisième phase de calcul comme la zone sous-tendue entre la tension de fonctionnement (Vc) lorsque ladite profondeur de décharge (DOD) varie.

8. Procédé selon la revendication 7, dans lequel les cellules (3) de chaque chaîne (2) sont connectées électriquement les unes aux autres en parallèle, lesdites chaînes étant électriquement connectées les unes aux autres en série, de telle sorte que ladite tension opérationnelle (Vc) soit sensiblement égale à la somme de la tension de chaque chaîne (2).

9. Procédé selon la revendication 7 ou 8, dans lequel le calcul de ladite valeur proportionnelle à l'énergie (Ac) est le calcul d'une intégrale numérique dans le temps de ladite tension à travers ladite chaîne (2) de cellules (3).

10. Procédé selon la revendication 9, dans lequel ladite énergie dispersée Ac est calculée selon la formule

$$A_c = \int DOD_f\ V_{ab}(t)DOD(t)dt$$

$DOD_i$ dans laquelle :

$$DOD(t) = \underline{\quad 1 \quad} \int t\ idt$$
$$3600\ C_{eff}\quad t_i$$

et dans laquelle $DOD_i$ est la profondeur de décharge au début de ladite phase de décharge et/ou de ladite phase de recharge et dans laquelle $DOD_f$ est la profondeur de décharge à la fin de ladite phase de décharge et/ou de ladite phase de recharge.

11. Procédé selon une ou plusieurs des revendications 2 à 10, dans lequel ladite énergie dispersée (Ac) est proportionnelle à la dégradation de ladite batterie (1).

12. Procédé selon une ou plusieurs des revendications précédentes, dans lequel il fournit des calculs numériques qui n'incluent pas de dérivées.

13. Dispositif de vérification de l'état de santé d'une batterie, configuré pour être connecté électriquement à un dispositif de gestion d'au moins une batterie, un tel dispositif de vérification de l'état de santé d'une batterie comprenant des moyens pour détecter des quantités électriques selon la revendication 1 et au moins une unité de commande électronique configurée pour recevoir lesdites quantités électriques programmée pour effectuer les étapes opérationnelles pour l'exécution du procédé de détermination de l'état de santé d'une batterie selon une ou plusieurs des revendications précédentes.

FIG. 1

FIG. 2

FIG. 3

FIG. 4

FIG. 5

E0, Vc

Ac

Vc(DOD) + R*Ic
Vc(DOD)
Vc(DOD) – R*Isc

DOD

FIG. 6

C1     C2     Vc(DOD)
                      C1
                             C2

C1>C2

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015260795 A1